(19) Europäisches Patentamt
European Patent Office
Office européen des brevets

(11) Veröffentlichungsnummer: **0 184 116**
**B1**

(12) **EUROPÄISCHE PATENTSCHRIFT**

(45) Veröffentlichungstag der Patentschrift: **19.04.89**

(51) Int. Cl.⁴: **C04B 35/46**, H01L 41/18

(21) Anmeldenummer: **85114993.0**

(22) Anmeldetag: **26.11.85**

(54) **Piezokeramik.**

(30) Priorität: **04.12.84 DE 3444177**

(43) Veröffentlichungstag der Anmeldung: **11.06.86 Patentblatt 86/24**

(45) Bekanntmachung des Hinweises auf die Patenterteilung: **19.04.89 Patentblatt 89/16**

(84) Benannte Vertragsstaaten: **DE FR GB**

(56) Entgegenhaltungen:
**PATENTS ABSTRACTS OF JAPAN, Band 6, Nr. 103 (E-112)[981], 12. Juni 1982; & JP - A - 57 35 388 (TOKYO SHIBAURA DENKI K.K.) 25-02-1982**
**CHEMICAL ABSTRACTS, Band 101, Nr. 16, Oktober 1984, Seite 736, Zusammenfassung Nr. 142394j, Columbus, Ohio, US; & JP - A - 59 17 983 (TOSHIBA CORP.) 24-04-1984**

(73) Patentinhaber: **Siemens Aktiengesellschaft Berlin und München, Wittelsbacherplatz 2, D-8000 München 2(DE)**

(72) Erfinder: **Wersing, Wolfram, Dipl.-Phys., Weidenweg 14, D-8011 Kirchheim(DE)**
Erfinder: **Mohaupt, Jutta, Theresienstrasse 54, D-8000 München 2(DE)**
Erfinder: **Lubitz, Karl, Dr., Röntgenstrasse 20, D-8012 Ottobrunn(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).



ACTORUM AG

## Beschreibung

Die vorliegende Erfindung bezieht sich auf eine Piezokeramik nach dem Oberbegriff des Patentanspruchs 1.

Aus der europäischen Patentanmeldung 0 103 304 ist eine Piezokeramik bekannt, die als Kationen Blei und Kalzium und als Anionen Titan, Niob und Magnesium oder Zink enthält, wobei das Verhältnis Niob zu Magnesium bzw. Niob zu Zink derart ist, daß sich Vierwertigkeit des entsprechenden Komplexes ergibt. Die übliche Schreibweise als chemische Formel ist die folgende:

$(Pb_{1-u}Ca_u)[(Me_{1/3}Nb_{2/3})_xTi_{1-x})]O_3$

Die vorstehend genannte Keramik gehört zur Gruppe der Bleititanate, die besondere Eigenschaften dahingehend haben, daß der Kopplungsfaktor $k_{33}$ der mechanischen Dickenresonanz eines Körpers aus diesem Material sehr viel größer ist als der entsprechende Koppelkoeffizient $k_{31}$ bzw. $k_p$ für die Querkopplung. Für die Verwendung als Ultraschall-Wandler, z.B. im medizinischen Bereich, bietet eine Piezokeramik mit einem zahlenmäßig großen Verhältnis $k_{33}/k_{31}$ Vorteile, da bei einem Wandler aus derartiger Keramik vorwiegend die Schwingungen des Dickenschwingungsmodes auftreten und unerwünschte Schwingungen der Quer- bzw. Transversalmoden klein sind. Einzelheiten hierzu sind aus der obengenannten Druckschrift zu entnehmen.

Aus der Druckschrift 'Izw. Akad. Nauk SSSR', Physikalische Reihe (1965), Seiten 2042 bis 2045 ist piezoelektrische Keramik des Systems Bleizirkonat-Titanat bekannt, bei der der Zirkon bzw. Titan ersetzende Komplexanteil aus Nickel und Niob in wiederum einem solchen Mengenverhältnis zueinander enthalten ist, daß sich für den Nickel-Niob-Komplex Vierwertigkeit ergibt. Die Formel einer solchen Keramik ist die folgende:

$Pb|(Ni_{1/3}Nb_{2/3})TiZr|O_3$.

Für diese bekannten Keramikmaterialien und analoge, hier nicht genannte Keramiksorten gilt, daß hinsichtlich der Bestandteile Kationen zu Anionen und auch innerhalb der Anionen Stöchiometrie der Mengenanteile besteht.

Aufgabe der vorliegenden Erfindung ist es, eine neue Zusammensetzung einer Piezokeramik zu finden, die ein besonders großes Verhältnis der Dickenkopplung ($k_{33}$) zur Querkopplung ($k_{31}$) und auch eine hohe Eigendämpfung besitzt. Sie soll außerdem hohe Dichte haben und sehr feinkörnig sein. Diese Piezokeramik läßt sich besonders vorteilhaft für Wandler mit sehr hoher Frequenz bis in den MHz-Bereich hinein verwenden.

Diese Aufgabe wird mit einer Piezokeramik auf der Basis des Bleititanats gelöst, deren Merkmale im Patentanspruch 1 angegeben sind.

Es liegen bereits eine erhebliche Anzahl Versuche und Untersuchungen vor, andere als stöchiometrische Zusammensetzungen für Piezokeramik zu wählen, um jeweils gewünschte Verbesserungen bzw. vorteilhaftere Eigenschaften zu erzielen, als sie bereits bekannte und durchentwickelte Piezokeramikmassen haben. Schon für Weiterentwicklungen auf dem Gebiet stöchiometrischer Piezokeramik der oben angegebenen Systeme ergibt sich eine große Vielzahl der Kombinationsmöglichkeiten der Zusammensetzungsvariationen, allein aufgrund der Vielzahl der für derartige Zusammensetzungsvariationen in Frage kommenden chemischen Elemente. Eine solche Vielzahl von Bleititanat-Zusammensetzungen und Bleizirkonattitanat-Zusammensetzungen ist aus dem einschlägigen Schrifttum aus mehr als zwei Jahrzehnten zurückliegender Zeit bekannt. Es sind auch bereits Untersuchungen solcher Systeme durchgeführt worden, bei denen bewußt von Stöchiometrie abgewichen worden ist. Ersichtlich ist außer der weiterhin hierfür bestehenden Vielfalt der Auswahl der enthaltenen chemischen Elemente eine geradezu ungeheure Vielzahl von Variationsmöglichkeiten nicht-stöchiometrischer Zusammensetzungen gegeben, innerhalb derer eine günstige Zusammensetzung zur Lösung der hier gestellten Aufgabe gesucht wurde, ohne daß zu erwarten war, daß es darunter überhaupt eine Zusammensetzung für die Lösung der Aufgabe geben wird.

Mit der angebenen erfindungsgemäßen Zusammensetzung einer nicht-stöchiometrischen Keramik, nämlich mit dem für das Verhältnis b/a (mit (a+b) = 1) angegebenen Zusammensetzungsbereich für den Nickel- und den Niobanteil, d.h. mit Nickelüberschuß, konnte tatsächlich das aufgabengemäß angestrebte Ziel erreicht werden. Unter "Grundzusammensetzung" ist zu verstehen, daß die erfindungsgemäße Keramik zusätzlich auch noch übliche Dotierung enthalten kann.

Eine wie erfindungsgemäße Keramik hat ein Verhältnis $k_{33}/k_{31}$ (Dickenkopplung/Querkopplung) bis herauf zu 40 und eine mechanische Güte, die unterhalb eines Wertes von etwa 100 liegt. Aufgrund dieser Eigenschaften eignet sich diese Keramik besonders gut für piezoelektrische Wandler, die zum Aussenden und/oder Empfang kurzer Ultraschall-Impulse dienen sollen und geeignet in der Ultraschall-Diagnostik angewendet werden können. Vorteilhafterweise hat die aufgefundene erfindungsgemäße Keramik die Eigenschaft hoher Dichte des Keramikgefüges und ist auch derart feinkörnig, daß die Korngröße unterhalb etwa 4 µm liegt. Eine solche Keramik ist besonders geeignet für die Herstellung sehr kleiner und dennoch homogener Wandlerkörper mit glatter Oberfläche, nämlich wie sie für Frequenzen z.B. im MHz-Bereich vorteilhaft sind. Derartige erfindungsgemäße Keramik ist auch feuchtigkeitsunempfindlich. Ein weiterer Vorteil derartiger Keramik ist, daß sie relativ hohe Frequenzkonstanz hinsichtlich der üblichen äußeren Einflüsse, die bei der praktischen Anwendung eine Rolle spielen, besitzt.

Die Herstellung einer erfindungsgemäßen Keramik erfolgt nach den an sich üblichen Verfahrensschritten, nämlich des Einwiegens der Ausgangsmaterialien, z.B. von Bleioxid, Kalziumkarbonat, Titandioxid, Nioboxid, Nickeloxid und dergleichen. Es können auch andere Verbindungen der jeweiligen chemischen Elemente verwendet werden. Das eingewogene Ausgangsmaterial wird gut gemahlen und gemischt, vorzugsweise in Kugelmühlen naßgemahlen. Nach dem Trocknen wird der Umsatz der Mischung durchgeführt, und zwar bei Temperaturen zwischen 800 und 100°C für eine Zeitdauer von 1 bis 10 Stunden. Nach Wiederzerkleinern des Sinterkuchens erfolgt das Pressen von Formkörpern aus dem umgesetzten Material, wobei zusätzlich übliches Bindemittel verwendet wird. Die gepreßten Körper werden dann bei vorzugsweise 1200 bis 1230 °C 1 bis 10 Stunden lang gesintert. Alternativ kann der Umsatz auch mit dem Sintern verbunden werden, wobei dann die Formgabe bereits mit dem gemischten und getrockneten Ausgangsmaterial durchgeführt wird. Jedoch kann der Fall eintreten, daß ein in dieser Weise ohne vorherigen Umsatz gesintertes Keramikmaterial nicht mehr so optimale elektrische Werte erreicht.

Die beigefügte Figur zeigt ein Flußdiagramm des Verfahrens, das zu der erfindungsgemäßen Keramik führt.

Bevorzugtes Anwendungsgebiet für diese Keramik ist die Ultraschalldiagnostik und -(Material-) Prüfung.

**Patentansprüche**

1. Piezoelektrisches Keramikmaterial auf der Basis des Bleititanats mit Niob als Zusatzelement in einem Komplexanteil, gekennzeichnet dadurch, daß dieses Keramikmaterial eine Grundzusammensetzung der Formel

$Pb_{1-u}Ca_u|Ti_{1-x}(Ni_aNb_b)_x|O_3$

mit den Grenzen

$0.2 < u < 0.3$
$0.04 < x < 0.3$
$1 < b/a < 1.9$

mit $(a+b) = 1$ hat.

2. Keramikmaterial nach Anspruch 1, gekennzeichnet dadurch, daß gilt

$0.04 < x < 0.06$.

3. Keramikmaterial nach Anspruch 1 oder 2, gekennzeichnet dadurch, daß gilt

$1.6 < b/a < 1.8$.

4. Verfahren zur Herstellung eines Piezokeramikmaterials nach Anspruch 1, 2 oder 3, gekennzeichnet dadurch, daß nach Einwiegen der Ausgangsmaterialien, Mischen, Mahlen und Trocknen der Umsatz bei 800 bis 1000°C 1 bis 10 Stunden durchgeführt wird und nach Zerkleinern und Pressen von Formkörpern das Sintern bei Temperaturen von 1200 bis 1230°C 1 bis 10 Stunden erfolgt.

**Claims**

1. Piezoelectric ceramic material based on lead titanate with niobium as added element in a complex fraction, characterized in that this ceramic material has a basic composition of the formula

$Pb_{1-u}Ca_u|Ti_{1-x}(Ni_aNb_b)_x|O_3$

with the limits

$0.2 < u < 0.3$
$0.04 < x < 0.3$
$1 < b/a < 1.9$

where $(a+b) = 1$.

2. Ceramic material according to Claim 1, characterized in that

$0.04 < x < 0.06$.

is valid.

3. Ceramic material according to Claim 1 or 2 characterized in that

$1.6 < b/a < 1.8$.

is valid.

4. Method of manufacturing a piezoceramic material according to Claim 1, 2 or 3, characterized in that after weighing-in the raw materials, mixing, grinding and drying, the calcination is performed at 800 to 1000°C for 1 to 10 hours, and after comminution and pressing of mouldings, sintering is effected at temperatures of 1200 to 1230°C for 1 to 10 hours.

**Revendications**

1. Céramique piézoélectrique à base de titanate de plomb, avec du niobium comme élément supplémentaire en une proportion donnant un complexe, caractérisé en ce que cette céramique a une composition de base répondant à la formule

$Pb_{1-u}Ca_u|Ti_{1-x}(Ni_aNb_b)_x|O_3$

avec les limites

$0.2 < u < 0.3$
$0.04 < x < 0.3$
$1 < b/a < 1.9$

et $(a+b) = 1$.

2. Céramique suivant la revendication 1, caractérisée en ce que,

$0.04 < x < 0.06$.

3. Céramique suivant la revendication 1 ou 2, caractérisée en ce que,

$1.6 < b/a < 1.8$.

4. Procédé de préparation d'une céramique piézoélectrique suivant la revendication 1, 2 ou 3, caractérisé en ce que, il consiste, après pesée des matériaux de mélange, broyage et séchage, à effectuer la réaction entre 800 et 1000°C pendant 1 à 10 heures et, après fragmentation et compression de corps façonnés, à effectuer le frittage à des températures de 1200 à 1230°C pendant 1 à 10 heures.

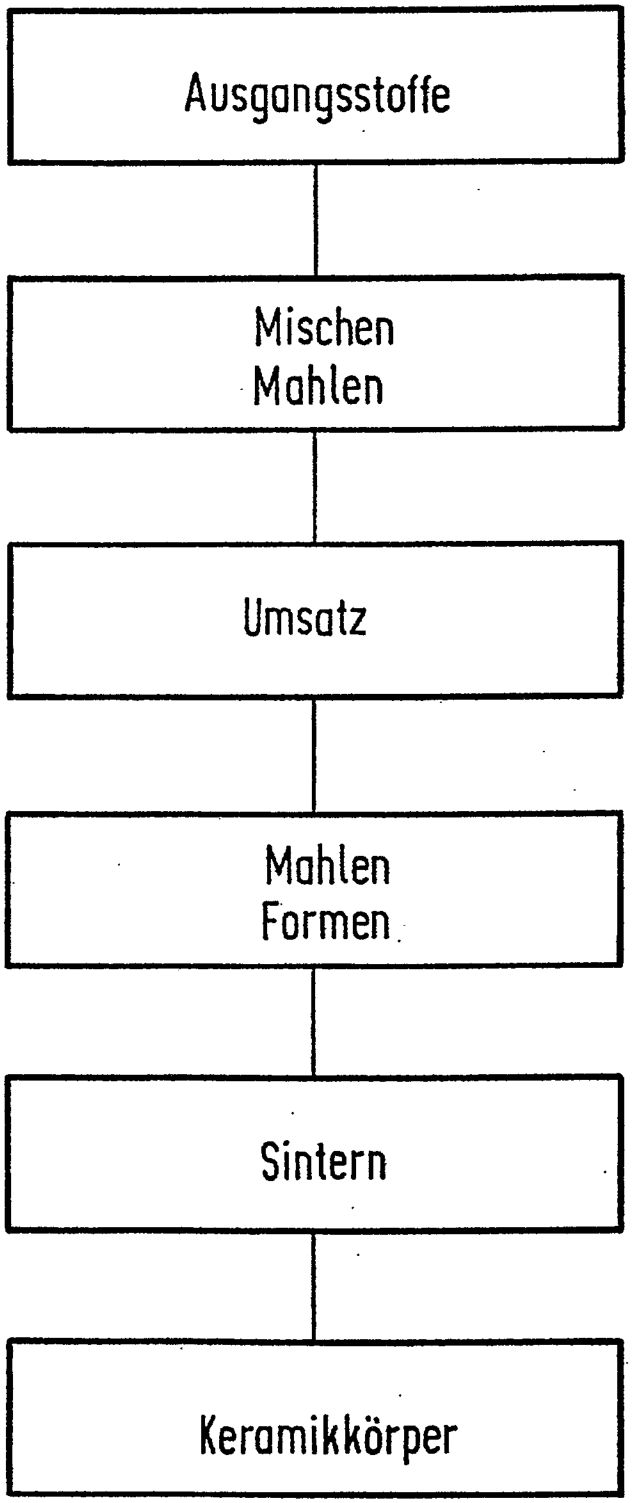
Ausgangsstoffe
Mischen
Mahlen
Umsatz
Mahlen
Formen
Sintern
Keramikkörper